# EUROPEAN PATENT APPLICATION

(11) **EP 1 195 613 A1**
(43) Date of publication of application: **10.04.2002**
(21) Application number: 00308807.7
(22) Date of filing: 06.10.2000
(51) Int. Cl.: G01R 31/319

(54) **Functionality testing of programmed devices**

(71) Applicant: Hewlett-Packard Company, A Delaware Corporation, Palo Alto, CA 94304 (US)
(72) Inventor: Watkins, Mark, Sneyd Park, Bristol BS9 ING (GB)
(74) Representative: Lawman, Matthew John Mitchell

(57) **Abstract**

The test system 100 comprises a scheduler 110 storing a database 130 of tests to be run on units under test (UUTs), e.g. as part of a procedure for approving firmware. The tests are allocated to appropriate test machines 112, 114 and 116 which execute the tests on UUTs such as 122, 124 and 126. The test system 100 allows tests to be run on UUTs in parallel and allows flexibility in the assignment of tests to appropriate test machines.

## Description

The invention relates to apparatus and a method for testing the functionality of programmed devices, so-called "units under test" (UUTs).

An example of a programmed device which requires functionality testing is a tape drive unit for a computer system, the tape drive unit being operated under the control of firmware resident on EEPROM-type memory within the unit. Naturally, it is important to test to ensure that the hardware of the tape drive unit interacts properly with the firmware and gives the correct functionality. It is not unusual for a large number of tests to be performed to fully evaluate a programmed device such as a tape drive unit.

A conventional procedure for testing the functionality of a UUT (such as a tape drive unit) involves connecting the UUT to a test machine which is capable of running the required tests on the UUT. The test machine has a memory containing all of the tests which need to be performed, and it performs the tests on the UUT in a serial manner. There are many drawbacks with this arrangement. Notably, if the UUT fails to pass a test, the execution of further tests is prevented to permit evaluation of the UUT to identify the cause of the failure. After the UUT has been inspected, testing is resumed, but normally the series of tests is begun again from the start. This may extend drastically the time taken to complete the full series of tests. It is not uncommon for a period of the order of tens of days to be required to complete a series of such tests.

To attempt to make the test procedure more efficient, it is known to divide a series of tests into several sub-series, and to run each sub-series on a separate test machine, each connected to a respective UUT. Although this may succeed in reducing the time taken to execute all the tests, it is still necessary to reinitialise a sub-series of tests upon failure of any one of the tests. Furthermore, an additional problem arises in that a larger number of test machines need to be monitored to determine if any of them has stalled through failure of a test.

It is an object of the invention to provide a more efficient way of executing functionality tests.

According to one aspect, the invention provides an apparatus for executing tests on programmed devices, comprising: a test executor arranged to execute tests on a plurality of programmed devices connected thereto; and a scheduler connected to the test executor and arranged to allocate the tests for execution on programmed devices by the executor.

According to another aspect the invention provides a method of testing a plurality of programmed devices, comprising: connecting the programmed devices to a test executor; allocating tests to the test executor from a scheduler; and executing said tests on the programmed devices under the control of the test executor.

Thus, the invention provides for the flexible scheduling of tests as and when programmed devices (UUTs) become available in the system. Advantageously, parallel execution of tests is also possible.

According to one embodiment, the test executor comprises a plurality of test machines, each of which is arranged to execute tests on one or more UUTs. The scheduler may take into account whether or not a test machine is appropriate to execute a test before allocating a test to it. For example, some test machines may have different test capabilities to others, i.e. they may be able to perform tests of different functions or tests under different operating (e.g. environmental) conditions.

Preferably, a test executor or a test machine is connected to the test scheduler via a local area network (LAN). Alternatively, the connection may be made through, for example, the internet.

Preferably, the outcomes of the tests are reported to the test scheduler, which takes further action as appropriate (e.g. indicating that attention to a fault in a UUT is required as a result of a test failure). Preferably, the test scheduler comprises a database containing the tests to be performed on the UUTs and data indicating whether the tests have been successful or not, once performed.

The UUTs may be modifiable. In one embodiment, the test executor or at least one test machine may be capable of modifying a UUT so that new tests may be performed on it. The modification may be by way of updating code in the UUT pertaining to its functionality.

To aid the understanding of the invention, certain embodiments of the invention will now be described, by way of example only, with reference to the accompanying drawings, in which:
Figure 1 is a block diagram illustrating a test system; and
Figure 2 is a block diagram illustrating a test machine.

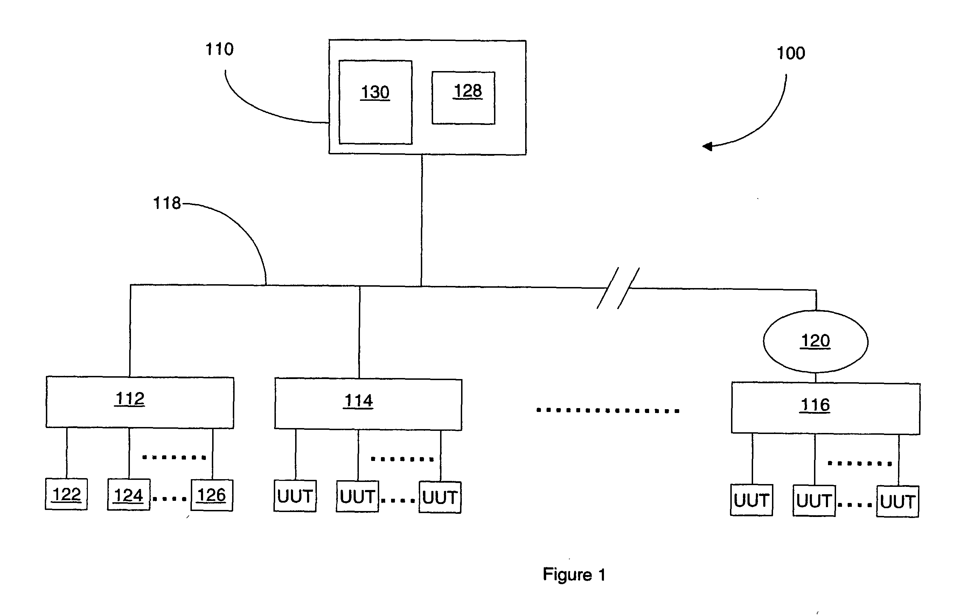

As shown in Figure 1, the test system 100 comprises a test scheduler 110 connected to a number of test machines 112, 114 and 116. Although only three test machines are shown, it will be apparent that the test system 100 may comprise any desired number of test machines. The test scheduler 110 communicates with test machines 112, 114 via local area network (LAN) 118. The test scheduler 110 also uses LAN 118 to communicate with test machine 116, but it will be noted that communication with test machine 116 takes place via the intermediary of the internet 120. It will be apparent that, in general terms, the test machines need not be located particularly close to one another or to the test scheduler 110.

Each of the test machines is connected to a number of units under test (UUTs). For example, three UUTs 122, 124 and 126 are shown connected to one test machine 112. However, it will be noted that in practice any number of UUTs may be connected to a test machine, provided that the test machine has the capability to support that number of UUTs.

The UUTs may all have the same characteristics or there may be subsets of UUTs, the members of each subset having the same characteristics. To illustrate the latter case, the UUTs could all comprise the same hardware but with each subset running a different version of a software product under test for that hardware. This allows the testing of different subsets of UUTs to be conducted in a flexible manner, or simultaneously.

The test scheduler 110 contains a processing unit 128 and a database 130. The database 130 contains the tests to be run on the UUTs and, in the case of each test that has been executed on a UUT, data indicating whether or not that test was executed successfully. The processing unit 128 allocates tests from database 130 to the test machines 112, 114, 116 for execution on UUTs.

The test machines 112, 114 and 116 need not have the same test capabilities. However it is envisaged that there will be an overlap of test capabilities between at least some of the test machines. The test capabilities of a test machine may mean that it is only able to perform some of the tests that need to be conducted on the UUTs.

The processing unit 128 of the test scheduler 110 allocates each test for execution by a test machine having regard to the test capabilities of the test machines and the availability of the UUTs at the test machines. For example, a test can only be allocated to a test machine which has the functional ability to execute that test. Even though the test machine has the appropriate functionality to execute a particular test, clearly it will not be able to execute that test if there are no suitable UUTs available (i.e. already engaged in a test) at that test machine. It would then be necessary to locate another test machine in the test system having the functionality to support that test and which has a suitable UUT that is currently free for use.

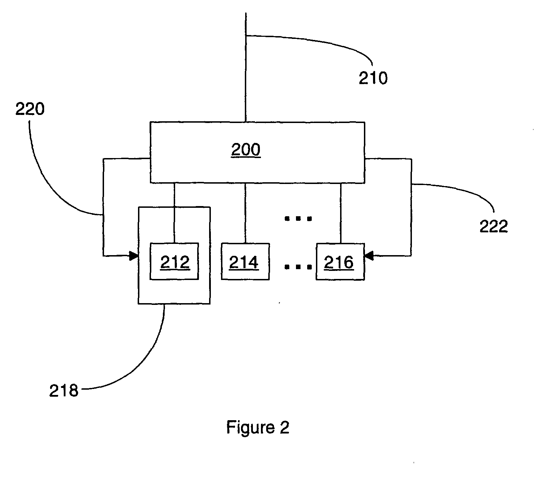

Figure 2 illustrates a test machine 200 in more detail. The connection to the scheduler 110 is indicated 210. A number of UUTs 212, 214, 216 are shown connected to the test machine 200. Again, it will be apparent that any number of UUTs may be connected to the test machine 200 provided that the maximum number of UUTs that can be supported by the test machine is not exceeded. UUT 212 is enclosed in an environmental chamber 218. The test machine 200 is capable of controlling the environmental conditions within environmental chamber 218 by way of signals conveyed on line 220. The environmental parameters of chamber 218 which may be controlled are temperature and humidity in this example. Test machine 200 is therefore capable of carrying out tests that need to be done under specific environmental conditions, or under specific controlled variation of environmental conditions.

UUT 216 is such that it can be modified. UUT 216 contains code, e.g. firmware, which can be reloaded or revised to modify the UUT. The modification of UUT 216 is performed by the test machine 200 over line 222. This may facilitate testing of, for example, different revisions of firmware intended for a product embodied by the UUT, e.g. a tape drive unit. The data for modifying a UUT may be stored locally within the test machine 200 or else it may be stored elsewhere in the test system 100 (for example, in database 130 of scheduler 110).

## Claims

1. Apparatus for executing tests on programmed devices, comprising:
a test executor arranged to execute tests on a plurality of programmed devices connected thereto; and
a scheduler connected to the test executor and arranged to allocate the tests for execution on said programmed devices by the executor.

2. Apparatus according to claim 1, wherein:
the test executor is capable of causing tests to be run on programmed devices in parallel.

3. Apparatus according to claim 1 or 2, wherein:
the test executor is arranged to report the outcome of tests performed on programmed devices.

4. Apparatus according to any one of claims 1 to 3, wherein:
the scheduler is connected to the test executor by at least one of a local area network and the internet.

5. Apparatus according to any one of claims 1 to 4, further comprising:
an adapter for modifying programmed devices to allow tests to be performed on modified programmed devices.

6. Apparatus according to claim 5 wherein:
the adapter is arranged to modify code within a programmed device.

7. Apparatus according to any one of claims 1 to 6, wherein:
the test executor comprises a plurality of test machines, each of which is connected to the scheduler, and arranged to execute tests on one or more programmed devices, and the scheduler is arranged to distribute the tests to the test machines for execution.

8. Apparatus according to claim 7, wherein:
the scheduler is arranged to distribute the tests by determining which of the test machines is appropriate to execute a test and to allocating said test to a test machine determined to be appropriate.

9. Apparatus according to claim 7 or 8, wherein:
the scheduler is arranged to determine appropriate test machines on the basis of the test machines' test capabilities.

10. Apparatus according to claim 9, wherein:
a test machine's test capabilities comprise at least one of its ability to perform predetermined functional tests and its ability to perform tests under predetermined environmental conditions.

11. Apparatus according to claim 9 or 10, wherein:
at least one test machine has different test capabilities to the other test machine or machines.

12. Apparatus according to claim 9, 10 or 11, wherein:
each test machine is arranged to signal its test capabilities to the scheduler.

13. Apparatus according to claim 7 to 12, wherein:
each test machine is capable of causing tests to be run on programmed devices in parallel.

14. Apparatus according to anyone of claims 7 to 13, wherein:
each test machine is arranged to report the outcome of tests performed on programmed devices.

15. Apparatus according to any one of claims 7 to 14, wherein:
the scheduler is connected to each test machine by at least one of a local area network and the internet.

16. A method of testing a plurality of programmed devices, comprising:
connecting the programmed devices to a test executor;
allocating tests to the test executor from a scheduler; and
executing said tests on the programmed devices under the control of the test executor.

17. A method according to claim 16, wherein:
said tests are executed on programmed devices in parallel.

18. A method according to claim 16 or 17, further comprising:
reporting the outcome of tests performed on the programmed devices.

19. A method according to any one of claims 16 to 18, further comprising:
modifying at least one programmed device before executing tests on said at least one programmed device.

20. A method according to claim 19, wherein:
modifying a programmed device comprises modifying code within a programmed device.

21. A method according to any one of claims 16 to 20, wherein:
the test executor comprises a plurality of test machines, each test machine being connected to at least one programmed device; and wherein
the tests are allocated to the test machines.

22. A method according to claim 21, wherein:
allocating the tests to test machines comprises determining which of the test machines is appropriate to execute a test and allocating said test to a test machine determined to be appropriate.

23. A method according to claim 22, wherein:
said determining step comprises determining if a test machine is appropriate on the basis of a test machine's capabilities.

24. Apparatus for executing tests on units under test (programmed devices), substantially as hereinbefore described with reference to Figure 1 or 2.

25. A method of executing tests on units under test (programmed devices), substantially as hereinbefore described with reference to Figure 1 or 2.
